Europäisches Patentamt

European Patent Office

Office européen des brevets

(19)

(11) Publication number: **0 187 601 B1**

# EUROPEAN PATENT SPECIFICATION

(12)

(45) Date of publication of patent specification: **13.03.91**   (51) Int. Cl.⁵: **H01L 21/31**

(21) Application number: **85402634.1**

(22) Date of filing: **26.12.85**

(54) Process for dry etching a silicon nitride layer.

(30) Priority: **29.12.84 JP 280138/84**

(43) Date of publication of application:
**16.07.86 Bulletin 86/29**

(45) Publication of the grant of the patent:
**13.03.91 Bulletin 91/11**

(84) Designated Contracting States:
**DE FR GB**

(56) References cited:
**EP-A- 0 109 706**
**DE-A- 3 420 347**

**IEEE TRANSACTIONS ON ELECTRON DE-
VICES, vol. ED-28, no. 11, November 1981,
pages 1332-1337, IEEE, New York, US; W.
BEINVOGL et al.: "Plasma etching of poly-
silicon and Si3N4 in SF6 with some impact
on MOS device characteristics"**

**Idem**

(73) Proprietor: **FUJITSU LIMITED**
**1015, Kamikodanaka Nakahara-ku
Kawasaki-shi Kanagawa 211(JP)**

(72) Inventor: **Shin, Teshiki
Yoshimiso, 133, Kamikodanaka Nakahara-ku
Kawasaki-shi Kanagawa 211(JP)**

(74) Representative: **Descourtieux, Philippe et al
CABINET BEAU de LOMENIE 55 rue
d'Amsterdam
F-75008 Paris(FR)**

## Description

BACKGROUND OF THE INVENTION

1. Field of the Invention

The present invention relates to a process for etching a silicon nitride layer. More specifically, it relates to a process for dry etching a silicon nitride layer on a silicon dioxide layer, useful in a so-called "local oxidation of silicon" (LOCOS) process.

2. Description of the Related Art

A silicon nitride ($Si_3N_4$) layer is used as a mask for locally oxidizing a semiconductor bulk, such as a silicon bulk. In this process (LOCOS), the overall surface of a silicon bulk is first oxidized to a thin thickness, e.g., 50 nm. Then, an $Si_3N_4$ layer of, e.g., 100 nm thickness is formed on the oxidized surface of the silicon bulk. The $Si_3N_4$ layer is patterned with a mask of a patterned resist layer formed on the $Si_3N_4$ layer, the resist layer is removed, then the silicon bulk is locally oxidized by using the patterned $Si_3N_4$ layer as a mask.

In this local oxidation process, there is the problem of formation of "bird beaks". That is, oxidation of the silicon bulk occurs not only vertically downward from the top surface of a portion of the silicon bulk not covered with the $Si_3N_4$ layer as mask but also horizontally toward a portion under the $Si_3N_4$ layer. These "bird beaks" create undesired wasteful areas in microcircuit devices, preventing densification of integrated circuit (IC) devices.

It is known that by decreasing the thickness of a silicon dioxide ($SiO_2$) layer formed on the surface of the silicon bulk and increasing the thickness of an $Si_3N_4$ layer or a mask layer for oxidation on the $SiO_2$ layer, it is possible to reduce the size of "bird beaks" formed during the local oxidation. However, no currently available etching process allows a desired combination of the thicknesses of the $SiO_2$ and $Si_3N_4$ layers. An etching gas comprising fluoromethane (freon), particularly tetrafluoromethane ($CF_4$), and oxygen ($O_2$) is typically used for dry etching an $Si_3N_4$ layer in the LOCOS process, which gas needs the above mentioned combination of thicknesses of the $SiO_2$ and $Si_3N_4$ layers of, e.g., 50 nm and 100 nm, respectively, since the above etching gas has a ratio of etching rate of $Si_3N_4$ to $SiO_2$ of about 2 to 3 at the highest. The above combination of the thicknesses of the two layers, i.e., 50 nm of the $SiO_2$ layer and 100 nm of the $Si_3N_4$ layers, not only requires severe control of the process conditions, but also results in "bird beaks" each having a width or lateral size of 0.3 to 0.4 μm.

If the thickness of the $SiO_2$ layer is further reduced in the above prior art process, the $SiO_2$ layer may be over etched during the patterning or etching of an $Si_3N_4$ layer on the $SiO_2$ layer, which causes nonuniform oxidation of the silicon bulk existing under the $SiO_2$ layer.

There are also known other dry etching gases, for example, a mixed gas of sulfur hexafluoride ($SF_6$) and chlorine ($Cl_2$) for etching silicon (Japanese Unexamined Patent Publication (Kokai) No. 58-7829); a gas of $SF_6$, nitrogen trifluoride ($NF_3$), fluorine ($F_2$), or $Cl_2$ for etching silicon (Japanese Unexamined Patent Publication (Kokai) No. 59-214226); a gas of $NF_3$ for etching $Si_3N_4$ - (Japanese Unexamined Patent Publication (Kokai) No. 60-20516); a reactive gas mixture comprising predominantly a fluorocarbon gas doped with carbon dioxide for etching an inorganic insulating layer comprising silicon as a main metal element (Japanese Unexamined Patent Publication (Kokai) No. 58-84113); and a combination of a fluorine-system gas such as $SF_6$ or $CF_4$ gas and a carbon-system gas such as ethylene ($C_2H_4$) or carbon tetrachloride ($C Cl_4$) for etching polycrystalline or crystalline silicon (Japanese Unexamined Patent Publication (Kokai) No. 59-51531). However, some of these publications, disclosing $SF_6$ as a dry etching gas, do not concern etching of $Si_3N_4$ and the others, disclosing a gas for dry etching $Si_3N_4$, are not very effective.

SUMMARY OF THE INVENTION

The main object of the present invention is to provide an effective dry etching process for etching $Si_3N_4$.

A further object of the present invention is to provide a dry etching process having a high ratio of etching rate of $Si_3N_4/SiO_2$, useful for the LOCOS process.

A still further object of the present invention is to reduce the size of "bird beaks" formed in the LOCOS process in order to densify semiconductor IC devices.

These and other objects are attained by a process for dry etching an $Si_3N_4$ layer with an etching gas comprising $SF_6$. This invention is based on a finding that $SF_6$ has a high effectivity of etching $Si_3N_4$ and a high selectivity of etching $Si_3N_4$ in relation to $SiO_2$ or a photoresist.

The etching gas further comprises fluoromethane such as $CH_3F$, $CH_2F_2$, $CHF_3$, and $CF_4$. A combination of $SF_6$ and $CH_2F_2$ is preferred.

We further found that anode coupling reactive ion etching is preferable in a process for dry etch-

ing an $Si_3N_4$ layer on an $SiO_2$ layer with an etching gas comprising $SF_6$ and $CH_2F_2$ since it allows a higher etching rate ratio of $Si_3N_4/SiO_2$, although other types of dry etching, for example, cathode coupling type, reactive ion etching, and downflow type plasma etching, may have some advantages in a process according to the present invention.

BRIEF DESCRIPTION OF THE DRAWINGS

Figure 1 is a schematic sectional view of an apparatus for dry etching used in a process according to the present invention;

Figs. 2A, 2B, and 2C are sectional views of a silicon bulk to be locally oxidized in some steps of the LOCOS process according to the present invention;

Fig. 3 is a graph of the etching rates of $Si_3N_4$ $SiO_2$, and resist when the flow rate of $CH_2F_2$ is varied; and

Fig. 4 is a graph of the selectivities of etching of $Si_3N_4$ to $SiO_2$ and resist when the flow rate of $CH_2F_2$ is varied.

DESCRIPTION OF THE PREFERRED EMBODIMENTS

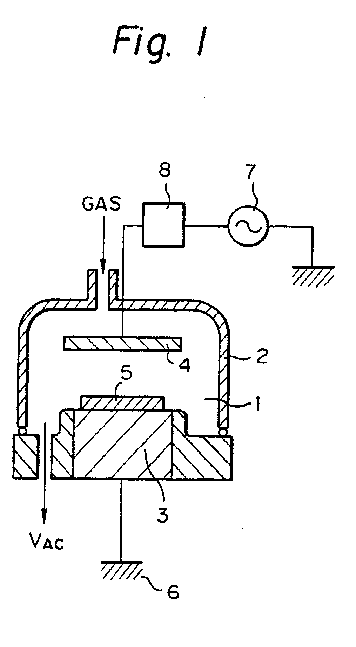

Figure 1 illustrates an anode coupling type dry etching apparatus. In a reaction chamber 1 defined by a quartz tube 2, there are parallel electrodes 3 and 4. An upper side electrode 4 is made of aluminum (Al) and anodized on its surface, and a lower side electrode 3 is made of aluminum on which a wafer 5 to be treated is placed. The lower side electrode 3 is connected to the ground 6, and the upper side electrode 4 is connected to a radio frequency (RF) source 7 of 13.56 MHz. A matching network 8 is inserted between the upper side electrode 4 and the RF source 7. The reaction chamber 1 is evacuated by a vacuum pump (not shown).

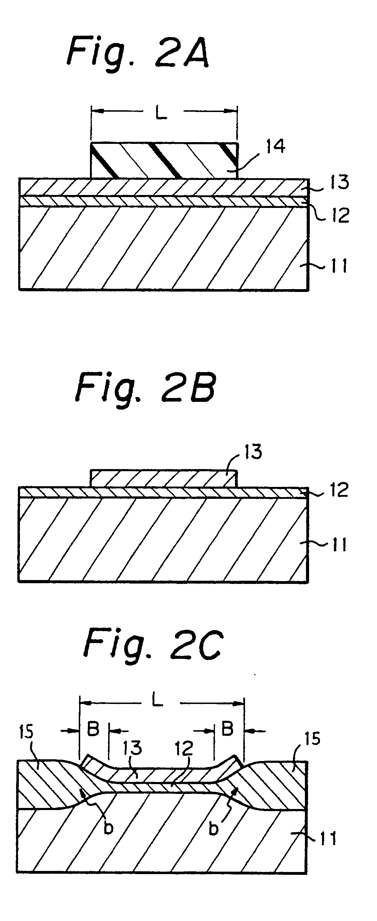

Now, an example of the LOCOS process according to the present invention is described with reference to Figs. 1, 2A, 2B, and 2C. In Fig. 2A a silicon (Si) bulk or wafer 11 was prepared and a surface of the silicon bulk 11 was oxidized to form an $SiO_2$ layer 12 of 30 nm thickness. An $Si_3N_4$ layer 13 was deposited onto the $SiO_2$ layer 12 by sputtering, etc. The thickness of the $Si_3N_4$ layer 13 was 100 nm in this case, but could have also been made 150 nm. A resist layer 14 was coated on the $Si_3N_4$ layer 13 and patterned to leave a square or rectangular shape having a size L of 2.5 μm.

In a dry etching apparatus as in Fig. 1, the wafer 1 was placed on the lower side electrode 3. A reaction gas of a mixture of $SF_6$ and $CH_2F_2$ with flow rates of 50 SCCM (standard cubic centimeter per minute) and 10 SCCM respectively, was introduced into the reaction chamber 1, which was evacuated to about 33Pa (0.25 Torr). A radio frequency of 13.56 MHz was applied between the two electrodes 3 and 4 at a power of about 125 Watts. By reactive ion etching under these conditions, a portion of the $Si_3N_4$ layer 13, which was not covered with the patterned resist layer 14, was selectively etched or removed. The resist layer 14 was then removed. Thus, a patterned $Si_3N_4$ layer 13 was obtained on the $SiO_2$ layer 12; the patterned $Si_3N_4$ layer 13 having a square or rectangular shape, as shown in Fig. 2B.

Referring to Fig. 2C, oxidation was carried out in which the patterned $Si_3N_4$ layer 13 was used as a mask to locally oxidize the silicon bulk 11, that is, a portion of the silicon bulk 11 above which no $Si_3N_4$ layer exists was oxidized to form a thick $SiO_2$ layer 15 or a locally oxidized silicon. In this oxidation, "bird beaks" b were formed but had the width B of only 0.2 μm to 0.3 μm which was reduced from the width of the "bird beaks" in the prior art.

In the prior art, for example, using an etching gas comprising $CF_4$ and $O_2$, as described before, the thickness of the $SiO_2$ layer had to be 50 nm if the $Si_3N_4$ layer had a thickness of 100 nm. This resulted in a width of the "bird beaks" of 0.3 μm to 0.4 μm after patterning the $Si_3N_4$ layer and oxidizing the silicon bulk under the $SiO_2$ layer using the $Si_3N_4$ layer as a mask.

In another experiment, the thickness of an $Si_3N_4$ layer was made 150 nm while maintaining the thickness of an $SiO_2$ layer at 30 nm. Successful selective etching of the $Si_3N_4$ layer could be done, that is, the $SiO_2$ layer was not overetched, resulting in excellent local oxidation of a silicon bulk under the $SiO_2$ layer.

Tests were made to ascertain preferable conditions of dry etching according to the present invention.

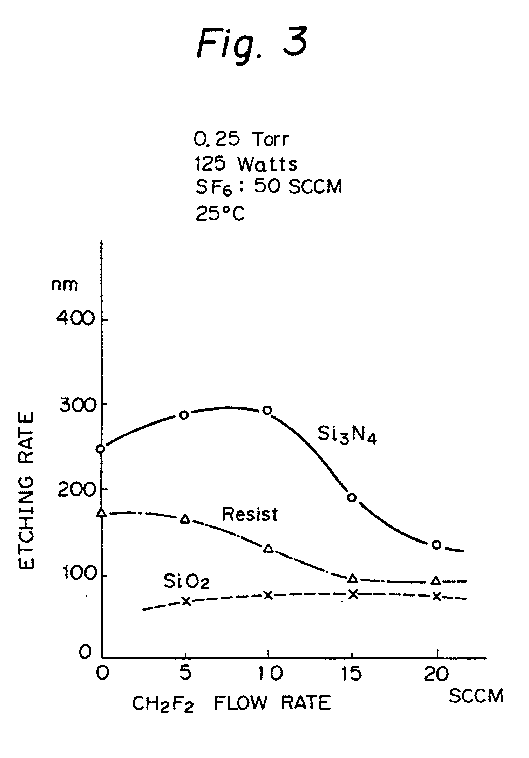

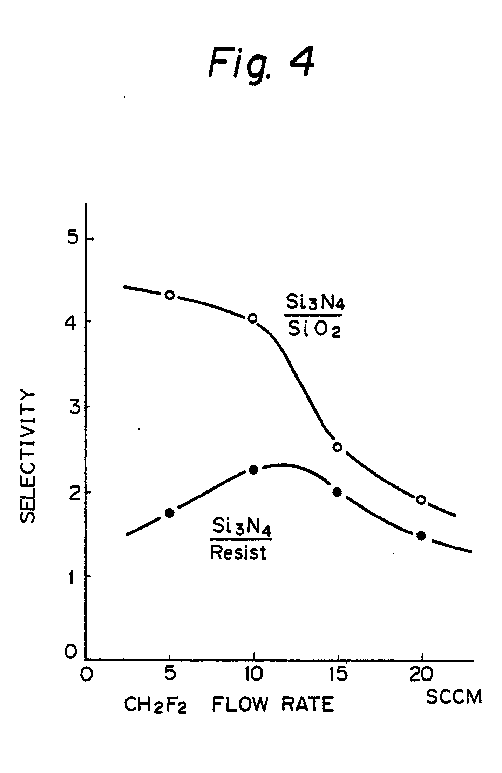

First, the flow rate of $CH_2F_2$ was varied with the other conditions being fixed. The fixed conditions of the test were vacuum of 33Pa (0.25 Torr), RF power of 125 Watts, flow rate of the $SF_6$ of 50 SCCM, and temperature of 25°C. Thus, the etching rates of an $Si_3N_4$ layer, an $SiO_2$ layer, and a resist layer (novolak resincontaining positive-type photosensitive resist, "ONPR-800 HSI," produced by Tokyo Oka K.K., Japan) were determined. The obtained etching rates and the selectivities of $Si_3N_4$ to $SiO_2$ and resist or ratios of the etching rate of $Si_3N_4$ to $SiO_2$ and resist, respectively, are summarized in the graphs in Figs. 3 and 4.

As can be seen in Figs. 3 and 4, a flow rate of $CH_2F_2$ in a range of 17.5 SCCM or less, preferably in a range of 4 to 12 SCCM, results in successful selectivity of etching of $Si_3N_4$ to $SiO_2$. It should be

noted that a selectivity of etching of $Si_3N_4$ to $SiO_2$ of more than 3, particularly, more than 4, was obtained in a process according to the present invention while at the highest only a selectivity of 2 to 3 could be obtained in a process in the prior art. It should be also noted that a relatively high selectivity of etching of $Si_3N_4$/resist was obtained and is also preferable.

Thus, a mixing ratio by volume or mole of $CH_2F_2$:$SF_6$ of up to 35:100, more preferably 8 - 24:100, particularly 20:100, is preferably used in a process according to the present invention. This fact was ascertained in another test in which the flow-rate of $SF_6$ is varied with the other conditions being fixed.

A third test in which the degree of vacuum in a reaction chamber was varied and the other conditions were fixed was carried out. We found that a vacuum of 13 to 40 Pa (0.1 to 0.3 Torr), more preferably 27-40 Pa (0.2 to 0.3 Torr), is preferably used.

A fourth test in which the RF power was varied and the other conditions were fixed was carried out. We found that 50 Watts was sufficient and 100 to 200 Watts was preferable for a process according to the invention.

## Claims

1. A process for dry etching a silicon nitride layer (13) with an etching gas comprising a combination of sulfur hexafluoride and fluoromethane.

2. A process according to claim 1, wherein said silicon nitride layer (13) is on a silicon dioxide layer (12) and a portion of said silicon nitride layer is selectively etched.

3. A process according to claim 1, wherein said fluoromethane is difluoromethane.

4. A process according to claim 2, wherein said silicon dioxide layer (12) has a thickness of less than 50 nm and said silicon nitride layer (13) has a thickness of 100 nm to 200 nm.

5. A process acoording to claim 4, wherein said silicon dioxide layer (12) has a thickness of about 30 nm and said silicon nitride layer (13) has a thickness of 100 nm to 150 nm.

6. A process according to claim 1, wherein said etching is carried out under a vacuum of 13 Pa (0.1 Torr) or more.

7. A process according to claim 6, wherein said vacuum is 27 to 40 (0.2 Torr to 0.3 Torr).

8. A process according to claim 3, wherein a feeding ratio of sulfur hexafluoride to difluoromethane by volume is up to 35:100.

9. A process according to claim 4, wherein the ratio of sulfur hexafluoride to difluoromethane is 8 - 24:100.

10. A process according to any one of claims 1 to 9, wherein said dry etching is reactive ion etching.

11. A process according to claim 10, wherein said reactive ion etching is carried out between electrodes (3,4) of anode coupled-type.

12. A process for forming locally oxidized silicon, comprising the steps of :
    preparing a silicon bulk (11);
    oxidizing a surface of the silicon bulk (11) to form a thin silicon dioxide layer (12) on the silicon bulk (11);
    forming a silicon nitride layer (13) on the silicon dioxide layer (12);
    forming a resist layer (14) on the silicon nitride layer (13);
    patterning the resist layer (14) to expose a portion of the silicon nitride layer (13);
    dry etching selectively said exposed portion using the patterned resist layer (14) as a mask, in which an etching gas comprising sulfur hexafluoride and flouromethane is used; and
    oxidizing selectively a portion of the silicon bulk (11) existing under the exposed portion of the silicon dioxide (12) using the selectively etched silicon nitride layer (13) as a mask, to form a locally oxidized silicon bulk.

## Revendications

1. Un procédé pour graver par voie sèche une couche de nitrure de silicium (13) par un gaz de gravure comprenant une combinaison d'hexafluorure de soufre et de fluorométhane.

2. Un procédé selon la revendication 1, selon lequel ladite couche de nitrure de silicium (13) se trouve sur une couche de dioxyde de silicium (12) et une portion de ladite couche de nitrure de silicium est gravée sélectivement.

3. Un procédé selon la revendication 1, selon lequel ledit fluorométhane est le difluorométhane.

4. Un procédé selon la revendication 2, selon lequel ladite couche de dioxyde de silicium (12) a une épaisseur inférieure à 50 nm et ladite couche de nitrure de silicium (13) a une épaisseur de 100 nm à 200 nm.

5. Un procédé selon la revendication 4, selon lequel ladite couche de dioxyde de silicium (12) a une épaisseur d'environ 30 nm et ladite couche de nitrure de silicium (13) a une épaisseur de 100 nm à 150 nm.

6. Un procédé selon la revendication 1, selon lequel ladite gravure est conduite sous un vide de 13 Pa (0,1 Torr) ou plus.

7. Un procédé selon la revendication 6, selon lequel ledit vide est de 27 à 40 Pa (0,2 Torr à 0,3 Torr).

8. Un procédé selon la revendication 3, selon lequel le rapport d'alimentation entre l'hexafluorure de soufre et le difluorométhane, en volume, peut atteindre 35:100.

9. Un procédé selon la revendication 4, selon lequel le rapport entre l'hexafluorure de soufre et le difluorométhane est de 8-24:100.

10. Un procédé selon l'une quelconque des revendications 1 à 9, selon lequel ladite gravure par voie sèche est une gravure ionique.

11. Un procédé selon la revendication 10, selon lequel ladite gravure ionique est conduite entre les électrodes (3, 4) du type à couplage d'anode.

12. Un procédé pour former localement du silicium oxydé comprenant les étapes suivantes :
préparation d'une pièce en silicium (11) ;
oxydation d'une surface de la pièce en silicium (11) pour former une couche mince de dioxyde de silicium (12) sur la pièce en silicium (11) ;
formation d'une couche de nitrure de silicium (13) sur la couche de dioxyde de silicium (12) ;
formation d'une couche de matériau photorésistant (14) sur la couche de nitrure de silicium (13) ;
formation d'un motif à la couche de matériau photorésistant (14) pour exposer une portion de la couche de nitrure de silicium (13) ;
gravure par voie sèche sélective de ladite portion exposée en utilisant la couche (14) de matériau photorésistant portant un motif comme un masque, dans laquelle on utilise un gaz de gravure comprenant de l'hexafluorure de soufre et du fluorométhane ; et oxydation sélective d'une portion de la pièce en silicium (11) se trouvant sous la portion exposée de dioxyde de silicium (12) en utilisant la couche (13) de nitrure de silicium sélectivement gravée comme un masque, pour former une pièce en silicium localement oxydée.

## Ansprüche

1. Verfahren zum Trockenätzen einer Siliciumnitridschicht (13) mit einem Ätzgas, das eine Kombination aus Schwefelhexafluorid und Fluormethan umfaßt.

2. Verfahren nach Anspruch 1, bei dem die genannte Siliciumnitridschicht (13) auf einer Siliciumdioxidschicht (12) ist und ein Abschnitt der genannten Siliciumnitridschicht selektiv geätzt wird.

3. Verfahren nach Anspruch 1, bei dem das genannte Fluormethan ein Difluormethan ist.

4. Verfahren nach Anspruch 2, bei dem die genannte Siliciumdioxidschicht (12) eine Dicke von weniger als 50 nm hat und die genannte Siliciumnitridschicht (13) eine Dicke von 100 nm bis 200 nm hat.

5. Verfahren nach Anspruch 4, bei dem die genannte Siliciumdioxidschicht (12) eine Dicke von ungefähr 30 nm hat und die genannte Siliciumnitridschicht (13) eine Dicke von 100 nm bis 150 nm hat.

6. Verfahren nach Anspruch 1, bei dem das genannte Ätzen unter einem Vakuum von 13 Pa (0,1 Torr) oder mehr durchgeführt wird.

7. Verfahren nach Anspruch 6, bei dem das genannte Vakuum 27 bis 40 Pa (0,2 Torr bis 0,3 Torr) beträgt.

8. Verfahren nach Anspruch 3, bei dem ein Zuführungsverhältnis von Schwefelhexafluorid zu Difluormethan, volumenmäßig, bis zu 35:100 beträgt.

9. Verfahren nach Anspruch 4, bei dem das Verhältnis von Schwefelhexafluorid zu Difluormethan 8 - 24:100 beträgt.

**10.** Verfahren nach einem der Ansprüche 1 bis 9, bei dem das genannte Trockenätzen ein reaktives Ionenätzen ist.

**11.** Verfahren nach Anspruch 10, bei dem das genannte reaktive Ionenätzen zwischen Elektroden (3, 4) vom Anodenkopplungstyp durchgeführt wird.

**12.** Verfahren zum Bilden von örtlich oxidiertem Silicium, mit den folgenden Schritten:

Herstellen eines Siliciumgrundkörpers (11);

Oxidieren einer Oberfläche des Siliciumgrundkörpers (11), um eine dünne Siliciumdioxidschicht (12) auf dem Siliciumgrundkörper (11) zu bilden;

Bilden einer Siliciumnitridschicht (13) auf der Siliciumdioxidschicht (12);

Bilden einer Resistschicht (14) auf der Siliciumnitridschicht (13);

Mustern der Resistschicht (14), um einen Abschnitt der Siliciumnitridschicht (13) zu exponieren;

selektives Trockenätzen des genannten exponierten Abschnittes unter Verwendung der gemusterten Resistschicht (14) als eine Maske, bei welchem ein Ätzgas verwendet wird, das Schwefelhexafluorid und Fluormethan umfaßt; und

selektives Oxidieren eines Abschnittes des Siliciumgrundkörpers (11), der unter dem exponierten Abschnitt des Siliciumdioxid existiert, unter Verwendung der selektiv geätzten Siliciumnitridschicht (13) als eine Maske, um einen lokal oxidierten Siliciumgrundkörper zu bilden.

# Fig. 1

## Fig. 2A

## Fig. 2B

## Fig. 2C

# Fig. 3

0.25 Torr
125 Watts
$SF_6$ : 50 SCCM
25°C

# Fig. 4